# EUROPEAN PATENT SPECIFICATION

(11) **EP 4 451 562 B1**
(45) Date of publication and mention of the grant of the patent: **23.09.2026**
(21) Application number: 23876175.3
(22) Date of filing: 24.05.2023
(51) Int. Cl.: H03H 1/00, H05K 1/14, H05K 1/02, H02M 3/335, H02M 3/00, H05K 3/36, H05K 3/3447

(54) **MULTI-LAYER STRUCTURE FILTER AND VEHICLE ONBOARD POWER SUPPLY DC/DC CONVERSION APPARATUS**
MEHRSCHICHTIGES STRUKTURFILTER UND GLEICHSTROM/GLEICHSTROM-UMWANDLUNGSVORRICHTUNG FÜR BORDSTROMVERSORGUNG EINES FAHRZEUGS
FILTRE À STRUCTURE MULTICOUCHE ET APPAREIL DE CONVERSION CC/CC D'ALIMENTATION ÉLECTRIQUE EMBARQUÉ DE VÉHICULE

(30) Priority: 10.10.2022 CN 202211238276
(43) Date of publication of application: 23.10.2024
(73) Proprietor: SHENZHEN VMAX NEW ENERGY (GROUP) CO., LTD, Shenzhen, Guangdong 518000 (CN)
(72) Inventor: FENG, Yingying, Shenzhen, Guangdong 518000 (CN); YAO, Shun, Shenzhen, Guangdong 518000 (CN); LIU, Ji, Shenzhen, Guangdong 518000 (CN); HE, Yao, Shenzhen, Guangdong 518000 (CN)
(74) Representative: Sun, Yiming
(86) International application number: PCT/CN2023/096103
(87) International publication number: WO 2024/077964

(56) References cited:
- CN-A- 110 022 133
- CN-A- 110 022 133
- CN-A- 115 514 335
- CN-U- 209 591 755
- CN-U- 209 591 755
- CN-U- 212 543 739
- CN-U- 214 476 925
- CN-U- 214 476 925
- US-A1- 2003 076 199
- US-A1- 2022 263 421

## Description

### FIELD OF THE INVENTION

The present invention relates to the technical field of multi-tier wave-filter, and an on-board power source DCDC conversion device in which the wave-filter is applied.

### BACKGROUND OF THE INVENTION

A gradual increase of on-board intelligent devices with development of new energy automobile technology continually raises a demand for output power of on-board power DCDC conversion products; in addition, a gradual increase in need for miniaturization of on-board power DCDC conversion products makes it achievable to decrease installation space, so that an entire vehicle has more space to arrange these new smart devices, thereby improving intelligentization, integration and comfortability of new energy vehicles. However, even if the output power of on-board power DCDC conversion products increased, the output current would increase correspondingly, posing a higher challenge to design of high-current wave-filters at their output end.

Therefore, it is an urgent technical problem to be solved in this field to provide a miniaturized and high-current wave-filter suitable for output ends of on-board power DCDC conversion products.

US2022263421A1 discloses a power converter including a power transformer having a body housing two secondary windings, the body having first and second opposing and substantially parallel planar faces, each of the secondary windings having respective first coils and second coils having respective terminals. The terminals of the first coils extend through the first face of the transformer body, and the terminals of the second coils extend through the second face of the transformer body. The converter further includes two printed circuit boards (PCBs) each disposed at a corresponding face of the transformer body, each PCB carrying switches and capacitors of a respective rectifier circuit connected to the terminals of the coils of the respective secondary winding, each PCB including external connections for connecting the rectifier circuits in parallel to form an output of the power converter.

CN214476925U discloses a multi-output circuit comprising a transformer T1 and a plurality of filter inductors, the input end of the transformer T1 is used for being connected with a power supply, the output end of the transformer T1 is connected with one ends of the filter inductors, and the transformer T1 and the filter inductors are subjected to magnetic device integration; the transformer T1 is provided with a plurality of magnetic core columns, the plurality of magnetic core columns are used for winding and outputting a filter inductor, and the transformer T1 and the filter inductor are subjected to magnetic device integration, so that the volume is reduced; meanwhile, due to the arrangement of multiple magnetic columns of the transformer T1, the primary winding is divided into multiple sections of sub-windings to be coupled with the secondary winding on a certain magnetic core column, the number of turns of the primary winding and the secondary winding of the forward and reverse excitation transformer T1 is reduced, the primary winding and the secondary winding are wound more tightly, the coupling coefficient is increased, and leakage inductance is reduced. Finally, the effect of improving the efficiency and the function density is achieved.

CN110022133A discloses a miniaturized inductive coupling type adjustable band-pass filter, and belongs to the technical field of filters. The structure mainly comprises a shell, an input electrode, an output electrode, a grounding electrode, three layers of grounding plates, inductors among different layers of the grounding plates and capacitors on the surface of the shell, the low-temperature co-fired ceramic technology is adopted, the grounding plates and the inductors are sintered in a ceramic substrate, and the capacitors are mounted on the upper surface of the shell. The device is simple in structure, low in cost, small in size and good in batch consistency, and is prepared by using a low-temperature co-fired ceramic technology; and meanwhile, the three layers of grounding plates separate different inductors and capacitors, parasitic and resonance caused by unnecessary coupling are avoided, and the filtering accuracy and quality factor are improved.

CN209591755U relates to the technical field of power electronic power supply conversion, in particular to an inductor assembly for a direct current-direct current converter. The inductor comprises a first-stage inductor and a second-stage inductor, wherein the first-stage inductor comprises a first-stage coil, the second-stage inductor comprises a copper bar, the first-stage coil and the copper bar are formed by winding a copper wire, one end of the copper wire is provided with an input terminal of the first-stage inductor, and the other end of the copper wire is provided with an output terminal of the second-stage inductor. The coils in the two stages of inductors are formed by winding the same copper flat wire, and the electrical connection terminals connected with an external circuit are directly arranged on the coils, so that the transition connection between the two stages of inductors is reduced, and the electrical connection with the external circuit is simplified.

### SUMMARY OF THE INVENTION

In order to solve the technical problem of absence of a miniaturized and high-current wave-filter suitable for output ends of on-board power DCDC conversion products existing in the prior art, the present invention provides a multi-tier wave-filter and an on-board power source DCDC conversion device in which the wave-filter is applied.

In order to solve the above technical problem, the present invention is set out in the appended set of claims.

Compared with the prior art, the present invention provides the multi-tier wave-filter and the on-board power source DCDC conversion device in which the wave-filter is applied and in view of the output-end filter in the DCDC converter of the on-board power DCDC conversion products proposes a design for the wave-filter having a multi-tier structure, which not only achieves miniaturizing the wave-filter and decreasing installation space, but also better enables the high-current path at the output end of the DCDC converter to have heat dissipation, filtering, shielding and other properties.

### BRIEF DESCRIPTION OF THE DRAWINGS

In order to more clearly illustrate the technical solutions in the examples of the present invention, we shall briefly describe the figures that are used for an explanation in the examples or the prior art as follows, but it is obvious that the figures in the following description are only involved in some examples of the present invention, so a person skilled in the art can also obtain other figures based on these figures without doing creative work.
Fig.1 is a topology diagram of the exampled multi-tier wave-filter according to the present invention.
Fig.2 is a diagram of the inductor used in the exampled multi-tier wave-filter in the present invention.
Fig.3 is an entire structure diagram of the exampled multi-tier wave-filter in the present invention.
Fig.4 is a diagram of the on-board power source DCDC conversion device used in the exampled multi-tier wave-filter in the present invention.

Reference numerals are as follows.
1-first-level output inductor; 11-first magnetic core; 12-first input pin; 13-output pin; 14-core seat; 2-first-tier PCB; 3-second-tier PCB; 31-first-level output capacitor; 311-first shell; 4-second-level output inductor; 41-filter output terminal; 411-installation seat; 412-output port; 413-connection copper flat-bar; 42-second magnetic core; 43-second input pin; 44-output copper flat-bar; 441-connection screw hole; 5-third-tier PCB; 51-second-level output capacitor; 511-second shell; 6-coil; 7-primary side power switch transistor; 8-transformer; 9-secondary side switch transistor; 10-housing.

### DETAILED DESCRIPTION OF SOME EMBODIMENTS

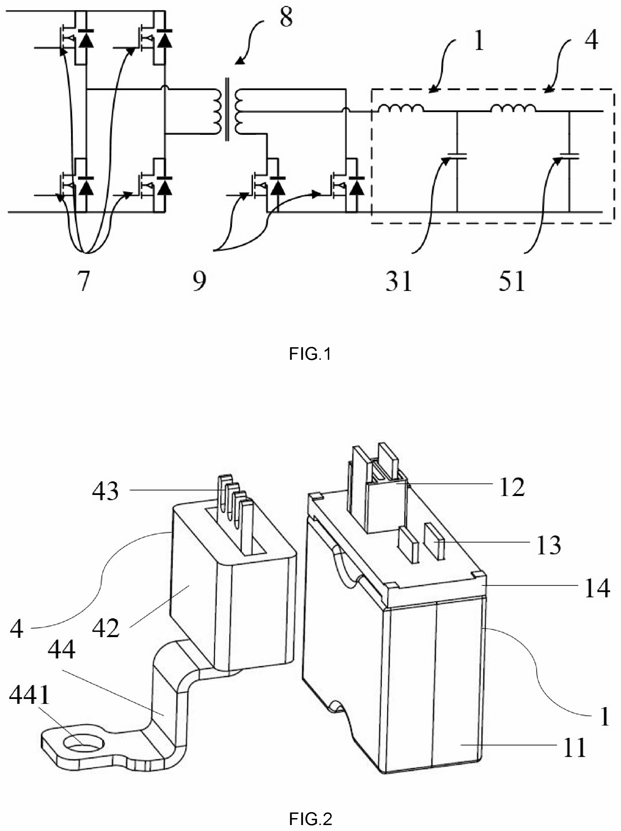

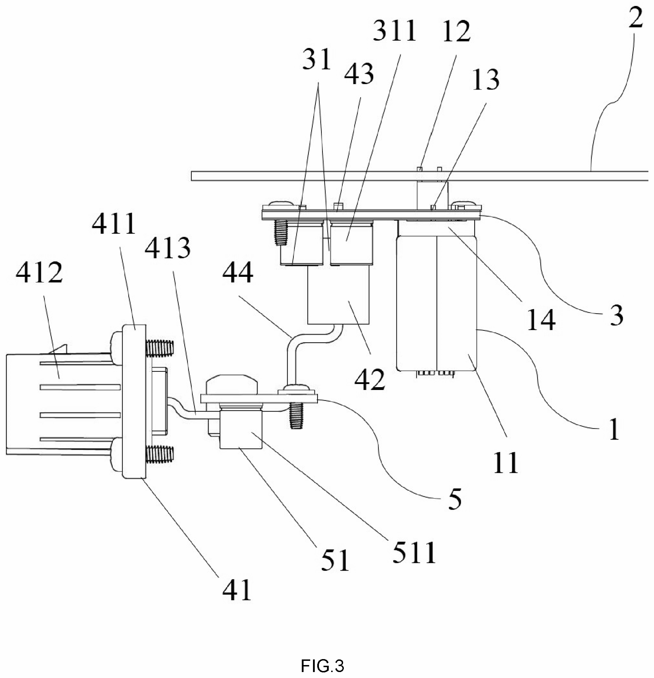

In order to make the technical problem, technical solution and beneficial effect to be solved by the present invention more clearly understood, we shall further describe the present invention in detail in combination with the figures 1-4 and examples as follows. It should be understood that the specific examples described herein are only used to explain the present invention, not to pose a limitation on the present invention.

Referring to Figs.1-4 together, a multi-tier wave-filter provided by the present invention includes N- tiered PCBs arranged at intervals from top to bottom, wherein N is greater than or equal to 3; N-1-level output inductors arranged at intervals from top to bottom, wherein an output inductor at each level is connected to adjacent upper-tier and lower-tier PCBs through its input end and output end, respectively; N-1-level output capacitors arranged at intervals from top to bottom, wherein an output capacitor at each level is correspondingly connected to PCBs between the second tier and the N^{th} tier, respectively; and a filter output terminal 41 connected to an output end of the N-1-level output inductor.

Referring to Fig.1, which is a typical diagram of the full-bridge topology of the DCDC circuit in which the primary and secondary sides are isolated, including a primary side power switch transistor 7, a transformer 8, a secondary side switch transistor 9, a first-level output inductor 1, a first-level output capacitor 31, a second-level output inductor 4 and a second-level output capacitor 51. Because the DCDC output voltage is about 14V and the DCDC output power is more than 2KW and 3KW, the DCDC output current is generally relatively high, about 100 amp or 200 amp or even high. The wave-filter structure on the high-current path at the output side of the DCDC circuit topology designed by the present invention and shown in the dashed frame in Fig.1, is composed of the first stage output inductor 1, the first-level output capacitor 31, the second-level output inductor 4 and the second-level output capacitor 51.

Referring to Figs.1-4 together, in Example 1 provided by the present invention, when N is equal to 3, an input end and an output end of the first-level output inductor 1 are correspondingly connected to the first-tier PCB 2 and the second-tier PCB 3, respectively. An input end and an output end of the second-level output inductor 4 are correspondingly connected to the second-tier PCB 3 and the third-tier PCB 5, respectively. The first-level output capacitor 31 and the second-level output capacitor 51 are correspondingly connected to the second-tier PCB 3 and the third-tier PCB5, respectivly, and the filter output terminal 41 is connected to an output end of the second-level output inductor 4.

Referring to Figs.2-3, in this example, the first-level output inductor 1 includes a first magnetic core 11 and at least two coils 6 disposed inside the first magnetic core 11 and connected in parallel with each other; a first input pin 12 and a output pin 13 are set on a top installation surface of the first magnetic core 11, and the terminal end of the first input pin 12 away from the first magnetic core 11 is higher than the terminal end of the output pin 13 away from the first magnetic core 11; the first input pin 12 and the output pin 13 are correspondingly connected to the first-tier PCB 2 and the second-tier PCB 3, respectively, and the top installation surface of the first magnetic core 11 is set against the bottom surface of the second-tier PCB 3; in other embodiments, there are three or more coils 6 connected in parallel with each other in the first magnetic core 11. A certain height difference, which can be soldered on the PCBs at different tiers, is formed between the first input pin 12 and the output pin 13, and finally forms the complete first-level output inductor 1 together with the external first magnetic core 11 and a core seat 14 or a shell of the first magnetic core 11.

As a preferred embodiment, the two sets of coils 6 connected in parallel of the first-level output inductor 1 are formed by way of winding a copper flat-bar into multi-turns, and the coil 6 of the second-level output inductor 4 is formed by winding a copper flat-bar into a single-turn. According to the analysis of the operation characteristics of components at each position in the circuit topology, a certain switching frequency current component occurs in the first-level output inductor 1, and in view of relative more capacity for the needed inductance, so a thin copper strip is winded into multi-turns to form a coil 6, which is used in parallel, so as to improve the inductance and reduce the skin effect; since the switching frequency current component in the second stage output inductor 4 is relatively small and can be basically ignored, and there is relatively less capacity for the needed inductance, the copper flat-bar is used to form a single-turn inductor coil 6.

Referring to Figs. 2-3, in this example, the first-level output capacitor 31 includes at least one first shell 311 installed on the bottom surface of the second-tier PCB 3 and a capacitance component set inside the first shell 311; as a preferred embodiment, the first-level output capacitor 31 includes two first shell 311 installed on the bottom surface of the second-tier PCB 3.

Referring to Figs.2-3, in this example, the second-level output inductor 4 includes a second magnetic core 42 and a coil 6 set inside the second magnetic core 42; a second input pin 43 is set on the top end face of the second magnetic core 42, and an output copper flat-bar 44 is set on the bottom end face of the second magnetic core 42; the second input pin 43 and the output copper flat-bar 44 are correspondingly connected to the second-tier PCB 3 and the third-tier PCB 5, respectively. According to actual demand on structure matching, the second input pin 43 and the output copper flat-bar 44 can form a flexible height difference and a matching mode to connect the front and rear levels, and the second magnetic core 42 enfolds the coil 6 of the copper flat-bar to finally form the second-level output inductor 4.

In this example, the second-level output capacitor 51 includes a second shell 511 installed on the bottom surface of the third-tier PCB 5 and a capacitance component set inside the second shell 511.

Referring to Figs. 2-3, in this example, the filter output terminal 41 is connected to the output copper flat-bar 44. As a preferred embodiment, the output copper flat-bar 44 is presented as a W shape, of the output copper flat-bar 44 one end is perpendicularly connected to the bottom end face of the second magnetic core 42, and the other end is struck to the bottom end surface of the third-tier PCB 5 after passing through the third-tier PCB 5. The first input pin 12 passes through the second-tier PCB 3, then is soldered to the first-tier PCB 2, and the output pin 13 and the second input pin 43 are soldered to the second-tier PCB 3. In other examples, the output copper flat-bar 44 may also be L-shaped or in other shapes.

In this example, the filter output terminal 41 includes an installation seat 411, an output port 412 arranged at one end of the installation seat 411 and the connection copper flat-bar 413 arranged at the other end of the installation seat 411; an installation screw hole is set at the other end of the connection copper flat-bar 413 away from the installation seat 411, and a connection screw hole 441 matching the installation screw hole is set at one end of the output copper flat-bar 44, thus the filter outp
ut terminal 41 is threadedly connected to the output copper flat-bar 44 by way of passing a fixing screw through the installation screw hole and the connection screw hole 441.

In other embodiments, the above soldering mode and threaded connection can be replaced by conventional soldering, resistance welding, laser welding, screw connection, riveting connection and other modes according to details at the connection point.

In Example 2 provided by the present invention (not shown in the figures), when Nis equal to 4, an input end and an output end of the first-level output inductor 1 are correspondingly connected to the first-tier PCB 2 and the second-tier PCB 3, respectively; an input end and an output end of the second-level output inductor 4 are correspondingly connected to the second-tier PCB 3 and the third-tier PCB 5, respectively; the first-level output capacitor 31 and the second-level output capacitor 51 are correspondingly connected to the second-tier PCB 3 and the third-tier PCB 5, respectively, and the filter output terminal 41 is connected to an output end of the second-level output inductor 4, an input end and an output end of the third-level output inductor are correspondingly connected to the second-tier PCB 3 and the third-tier PCB 5, respectively; an input end and an output end of the fourth-level output inductor are correspondingly connected to the third-tier PCB 5 and the second-tier PCB 3, respectively; the fourth level output capacitor is connected to the fourth-tier PCB, and the filter output terminal 41 is connected to an output end of the third-level output inductor.

In other examples (not shown in the figures), N may also be a value equal to or higher than 5.

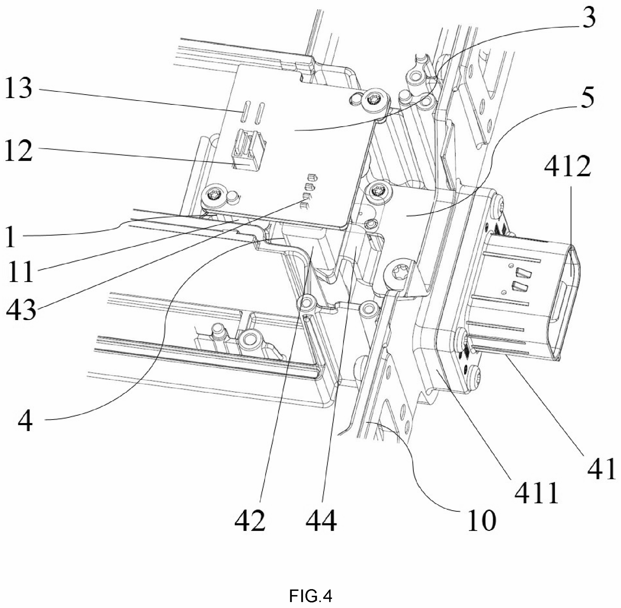

Referring to FIG. 4, the present invention also provides an on-board power source DCDC conversion device, including a housing 10, further including the above-mentioned multi-tier wave-filter installed on the housing 10, and a power switch transistor, a transformer 8 and a secondary side switch transistor 9 that are connected to the first-tier PCB 2.

In this example, the housing 10 forms a cavity used to isolate and shield inductance between the first-level output inductor 1 and the second-level output inductor 4 (not shown in the figures).

In this example, a heat conduction part is mounted between the first-level output inductor 1 as well as the second-level output inductor 4 and the housing 10 (not shown in the figures).

The above content only acts as a better embodiment of the present invention, not used to pose any limitation on the present invention, and any modifications, equivalent substitutions, improvements and the likes made within the essence and principle of the present invention will fall within the protection scope as defined by the appended claims.

## Claims

1. A multi-tier wave-filter comprising:
N-tiered PCBs (2, 3, 5) arranged at intervals from top to bottom, wherein N is greater than or equal to 3;
N-1-level output inductors (1, 4) arranged at intervals from top to bottom, wherein an output inductor at each level is connected to adjacent upper-tier and lower-tier PCBs through its input end and output end, respectively;
N-1-level output capacitors (31, 51) arranged at intervals from top to bottom, wherein an output capacitor at each level is correspondingly connected to PCBs between a second tier and a N^{th} tier, respectively; and
a filter output terminal (41) connected to an output end of the N-1-level output inductor,
wherein when N is equal to 3, an input end and an output end of a first-level output inductor (1) are correspondingly connected to a first-tier PCB (2) and a second-tier PCB (3), respectively; an input end and an output end of a second-level output inductor (4) are correspondingly connected to the second-tier PCB and a third-tier PCB (5), respectively; a first-level output capacitor (31) and a second-level output capacitor (51) are correspondingly connected to the second-tier PCB and the third-tier PCB, respectively; the filter output terminal is connected to an output end of the second-level output inductor,
wherein the first-level output inductor includes a first magnetic core (11) and at least two coils (6) disposed inside the first magnetic core and connected in parallel with each other; a first input pin (12) and an output pin (13) are set on a top installation surface of the first magnetic core, and a terminal end of the first input pin away from the first magnetic core is higher than a terminal end of the output pin away from the first magnetic core; the first input pin and the output pin are correspondingly connected to the first-tier PCB and the second-tier PCB, respectively, and the top installation surface of the first magnetic core is set against a bottom surface of the second-tier PCB;
the first-level output capacitor includes at least one first shell (311) installed on the bottom surface of the second-tier PCB and a capacitance component set inside the first shell;
the second-level output inductor includes a second magnetic core (42) and a coil set inside the second magnetic core; a second input pin (43) is set on a top end face of the second magnetic core, and an output copper flat-bar (44) is set on a bottom end face of the second magnetic core; the second input pin and the output copper flat-bar are correspondingly connected to the second-tier PCB and the third-tier PCB, respectively;
the second-level output capacitor includes a second shell (511) installed on a bottom surface of the third-tier PCB and a capacitance component set inside the second shell;
the filter output terminal is connected to the output copper flat-bar.

2. The multi-tier wave-filter according to claim 1, wherein when N is equal to 4, an input end and an output end of a third-level output inductor are correspondingly connected to the second-tier PCB and a third-tier PCB, respectively; an input end and an output end of a fourth-level output inductor are correspondingly connected to the third-tier PCB and the second-tier PCB, respectively; a fourth level output capacitor is connected to a fourth-tier PCB, and the filter output terminal is connected to an output end of the third-level output inductor.

3. The multi-tier wave-filter according to claim 1, wherein a coil of the first-level output inductor is formed by way of winding a copper flat-bar into multi-turns, and the coil of the second-level output inductor is formed by winding a copper flat-bar into a single-turn.

4. The multi-tier wave-filter according to claim 1, wherein of the output copper flat-bar one end is perpendicularly connected to the bottom end face of the second magnetic core, and the other end is stuck to the bottom end surface of the third-tier PCB after passing through the third-tier PCB, the first input pin passes through the second-tier PCB, then is soldered to the first-tier PCB, and the output pin and the second input pin are soldered to the second-tier PCB.

5. The multi-tier wave-filter according to claim 4, wherein the filter output terminal includes an installation seat (411), an output port (412) arranged at one end of the installation seat and a connection copper flat-bar (413) arranged at the other end of the installation seat; an installation screw hole is set at one end of the connection copper flat-bar far away from the installation seat, and a connection screw hole (441) matching the installation screw hole is set at the other end of the output copper flat-bar, thus the filter output terminal is connected to the output copper flat-bar by way of passing a fixing screw through the installation screw hole and the connection screw hole.

6. An on-board power source DCDC conversion device, comprising a housing (10), wherein the device further includes the multi-tier wave-filter as claimed in any one of claims 1 to 5 installed on the housing, and a power switch transistor (7), a transformer (8) and a secondary side switch transistor (9) that are connected to the first-tier PCB.

7. The on-board power source DCDC conversion device according to claim 6, wherein the housing forms a cavity used to isolate and shield inductance between a first-level output inductor (1) and a second-level output inductor (4).

8. The on-board power source DCDC conversion device according to claim 6, wherein a heat conduction part (20) is mounted between the first-level output inductor as well as the second-level output inductor and the housing.

## Patentansprüche

1. Ein Mehrebenen-Wellenfilter, umfassend:
PCBs (2, 3, 5) auf N Ebenen, die in Abständen von oben nach unten angeordnet sind, wobei N größer als oder gleich 3 ist;
Ausgangsinduktivitäten (1, 4) auf N-1 Stufen, die in Abständen von oben nach unten angeordnet sind, wobei eine Ausgangsinduktivität auf jeder Stufe über ihr Eingangsende beziehungsweise ihr Ausgangsende mit benachbarten PCBs einer oberen Ebene beziehungsweise einer unteren Ebene verbunden ist;
Ausgangskondensatoren (31, 51) auf N-1 Stufen, die in Abständen von oben nach unten angeordnet sind, wobei ein Ausgangskondensator auf jeder Stufe jeweils entsprechend mit PCBs zwischen einer zweiten Ebene und einer N-ten Ebene verbunden ist; und
einen Filterausgangsanschluss (41), der mit einem Ausgangsende der Ausgangsinduktivität der N-1. Stufe verbunden ist,
wobei, wenn N gleich 3 ist, ein Eingangsende und ein Ausgangsende einer Ausgangsinduktivität der ersten Stufe (1) entsprechend mit einem PCB der ersten Ebene (2) beziehungsweise einem PCB der zweiten Ebene (3) verbunden sind; ein Eingangsende und ein Ausgangsende einer Ausgangsinduktivität der zweiten Stufe (4) entsprechend mit dem PCB der zweiten Ebene beziehungsweise einem PCB der dritten Ebene (5) verbunden sind; ein Ausgangskondensator der ersten Stufe (31) und ein Ausgangskondensator der zweiten Stufe (51) entsprechend mit dem PCB der zweiten Ebene beziehungsweise dem PCB der dritten Ebene verbunden sind; der Filterausgangsanschluss mit einem Ausgangsende der Ausgangsinduktivität der zweiten Stufe verbunden ist,
wobei die Ausgangsinduktivität der ersten Stufe einen ersten Magnetkern (11) und mindestens zwei Spulen (6) umfasst, die innerhalb des ersten Magnetkerns angeordnet und parallel miteinander verbunden sind; ein erster Eingangsstift (12) und ein Ausgangsstift (13) an einer oberen Montagefläche des ersten Magnetkerns angeordnet sind, und ein von dem ersten Magnetkern entferntes Anschlussende des ersten Eingangsstifts höher ist als ein von dem ersten Magnetkern entferntes Anschlussende des Ausgangsstifts; der erste Eingangsstift und der Ausgangsstift entsprechend mit dem PCB der ersten Ebene beziehungsweise dem PCB der zweiten Ebene verbunden sind, und die obere Montagefläche des ersten Magnetkerns gegen eine Unterseite des PCB der zweiten Ebene angeordnet ist;
der Ausgangskondensator der ersten Stufe mindestens eine erste Schale (311), die an der Unterseite des PCB der zweiten Ebene installiert ist, und eine innerhalb der ersten Schale angeordnete Kapazitätskomponente umfasst;
die Ausgangsinduktivität der zweiten Stufe einen zweiten Magnetkern (42) und eine innerhalb des zweiten Magnetkerns angeordnete Spule umfasst; ein zweiter Eingangsstift (43) an einer oberen Stirnfläche des zweiten Magnetkerns angeordnet ist, und eine Ausgangs-Kupferflachschiene (44) an einer unteren Stirnfläche des zweiten Magnetkerns angeordnet ist; der zweite Eingangsstift und die Ausgangs-Kupferflachschiene entsprechend mit dem PCB der zweiten Ebene beziehungsweise dem PCB der dritten Ebene verbunden sind;
der Ausgangskondensator der zweiten Stufe eine zweite Schale (511), die an einer Unterseite des PCB der dritten Ebene installiert ist, und eine innerhalb der zweiten Schale angeordnete Kapazitätskomponente umfasst;
der Filterausgangsanschluss mit der Ausgangs-Kupferflachschiene verbunden ist.

2. Der Mehrebenen-Wellenfilter nach Anspruch 1, wobei, wenn N gleich 4 ist, ein Eingangsende und ein Ausgangsende einer Ausgangsinduktivität der dritten Stufe entsprechend mit dem PCB der zweiten Ebene beziehungsweise einem PCB der dritten Ebene verbunden sind; ein Eingangsende und ein Ausgangsende einer Ausgangsinduktivität der vierten Stufe entsprechend mit dem PCB der dritten Ebene beziehungsweise dem PCB der zweiten Ebene verbunden sind; ein Ausgangskondensator der vierten Stufe mit einem PCB der vierten Ebene verbunden ist und der Filterausgangsanschluss mit einem Ausgangsende der Ausgangsinduktivität der dritten Stufe verbunden ist.

3. Der Mehrebenen-Wellenfilter nach Anspruch 1, wobei eine Spule der Ausgangsinduktivität der ersten Stufe durch Wickeln einer Kupferflachschiene zu mehreren Windungen gebildet ist und die Spule der Ausgangsinduktivität der zweiten Stufe durch Wickeln einer Kupferflachschiene zu einer einzelnen Windung gebildet ist.

4. Der Mehrebenen-Wellenfilter nach Anspruch 1, wobei von der Ausgangs-Kupferflachschiene ein Ende senkrecht mit der unteren Stirnfläche des zweiten Magnetkerns verbunden ist und das andere Ende nach dem Hindurchtreten durch das PCB der dritten Ebene an die untere Endfläche des PCB der dritten Ebene angeklebt ist, der erste Eingangsstift durch das PCB der zweiten Ebene hindurchtritt und dann an das PCB der ersten Ebene angelötet ist, und der Ausgangsstift und der zweite Eingangsstift an das PCB der zweiten Ebene angelötet sind.

5. Der Mehrebenen-Wellenfilter nach Anspruch 4, wobei der Filterausgangsanschluss einen Montagesitz (411), einen an einem Ende des Montagesitzes angeordneten Ausgangsport (412) und eine an dem anderen Ende des Montagesitzes angeordnete Verbindungs-Kupferflachschiene (413) umfasst; ein Montageschraubenloch an einem von dem Montagesitz entfernten Ende der Verbindungs-Kupferflachschiene angeordnet ist, und ein zu dem Montageschraubenloch passendes Verbindungsschraubenloch (441) an dem anderen Ende der Ausgangs-Kupferflachschiene angeordnet ist, wodurch der Filterausgangsanschluss mit der Ausgangs-Kupferflachschiene verbunden ist, indem eine Befestigungsschraube durch das Montageschraubenloch und das Verbindungsschraubenloch hindurchgeführt wird.

6. Eine fahrzeugseitige DCDC-Stromquellen-Umwandlungsvorrichtung, umfassend ein Gehäuse (10), wobei die Vorrichtung ferner den nach einem der Ansprüche 1 bis 5 beanspruchten Mehrebenen-Wellenfilter, der an dem Gehäuse installiert ist, sowie einen Leistungsschalttransistor (7), einen Transformator (8) und einen sekundärseitigen Schalttransistor (9), die mit dem PCB der ersten Ebene verbunden sind, umfasst.

7. Die fahrzeugseitige DCDC-Stromquellen-Umwandlungsvorrichtung nach Anspruch 6, wobei das Gehäuse einen Hohlraum bildet, der zum Isolieren und Abschirmen der Induktivität zwischen einer Ausgangsinduktivität der ersten Stufe (1) und einer Ausgangsinduktivität der zweiten Stufe (4) verwendet wird.

8. Die fahrzeugseitige DCDC-Stromquellen-Umwandlungsvorrichtung nach Anspruch 6, wobei ein Wärmeleitungsteil (20) zwischen der Ausgangsinduktivität der ersten Stufe sowie der Ausgangsinduktivität der zweiten Stufe und dem Gehäuse montiert ist.

## Revendications

1. Un filtre d'ondes à plusieurs étages, comprenant :
des PCB (2, 3, 5) à N étages agencés à intervalles de haut en bas, dans lequel N est supérieur ou égal à 3 ;
des inductances de sortie (1, 4) à N-1 niveaux agencées à intervalles de haut en bas, dans lequel une inductance de sortie à chaque niveau est connectée à des PCB adjacents d'un étage supérieur et d'un étage inférieur par son extrémité d'entrée et son extrémité de sortie, respectivement ;
des condensateurs de sortie (31, 51) à N-1 niveaux agencés à intervalles de haut en bas, dans lequel un condensateur de sortie à chaque niveau est connecté de manière correspondante à des PCB entre un deuxième étage et un N-ième étage, respectivement ; et
une borne de sortie de filtre (41) connectée à une extrémité de sortie de l'inductance de sortie du N-1-ième niveau,
dans lequel, lorsque N est égal à 3, une extrémité d'entrée et une extrémité de sortie d'une inductance de sortie de premier niveau (1) sont connectées de manière correspondante à un PCB de premier étage (2) et à un PCB de deuxième étage (3), respectivement ; une extrémité d'entrée et une extrémité de sortie d'une inductance de sortie de deuxième niveau (4) sont connectées de manière correspondante au PCB de deuxième étage et à un PCB de troisième étage (5), respectivement ; un condensateur de sortie de premier niveau (31) et un condensateur de sortie de deuxième niveau (51) sont connectés de manière correspondante au PCB de deuxième étage et au PCB de troisième étage, respectivement ; la borne de sortie de filtre est connectée à une extrémité de sortie de l'inductance de sortie de deuxième niveau,
dans lequel l'inductance de sortie de premier niveau comprend un premier noyau magnétique (11) et au moins deux bobines (6) disposées à l'intérieur du premier noyau magnétique et connectées en parallèle les unes avec les autres ; une première broche d'entrée (12) et une broche de sortie (13) sont disposées sur une surface de montage supérieure du premier noyau magnétique, et une extrémité terminale de la première broche d'entrée éloignée du premier noyau magnétique est plus haute qu'une extrémité terminale de la broche de sortie éloignée du premier noyau magnétique ; la première broche d'entrée et la broche de sortie sont connectées de manière correspondante au PCB de premier étage et au PCB de deuxième étage, respectivement, et la surface de montage supérieure du premier noyau magnétique est disposée contre une surface inférieure du PCB de deuxième étage ;
le condensateur de sortie de premier niveau comprend au moins une première coque (311) installée sur la surface inférieure du PCB de deuxième étage et un composant capacitif disposé à l'intérieur de la première coque ;
l'inductance de sortie de deuxième niveau comprend un deuxième noyau magnétique (42) et une bobine disposée à l'intérieur du deuxième noyau magnétique ; une deuxième broche d'entrée (43) est disposée sur une face d'extrémité supérieure du deuxième noyau magnétique, et une barre plate en cuivre de sortie (44) est disposée sur une face d'extrémité inférieure du deuxième noyau magnétique ; la deuxième broche d'entrée et la barre plate en cuivre de sortie sont connectées de manière correspondante au PCB de deuxième étage et au PCB de troisième étage, respectivement ;
le condensateur de sortie de deuxième niveau comprend une deuxième coque (511) installée sur une surface inférieure du PCB de troisième étage et un composant capacitif disposé à l'intérieur de la deuxième coque ;
la borne de sortie de filtre est connectée à la barre plate en cuivre de sortie.

2. Le filtre d'ondes à plusieurs étages selon la revendication 1, dans lequel, lorsque N est égal à 4, une extrémité d'entrée et une extrémité de sortie d'une inductance de sortie de troisième niveau sont connectées de manière correspondante au PCB de deuxième étage et à un PCB de troisième étage, respectivement ; une extrémité d'entrée et une extrémité de sortie d'une inductance de sortie de quatrième niveau sont connectées de manière correspondante au PCB de troisième étage et au PCB de deuxième étage, respectivement ; un condensateur de sortie de quatrième niveau est connecté à un PCB de quatrième étage, et la borne de sortie de filtre est connectée à une extrémité de sortie de l'inductance de sortie de troisième niveau.

3. Le filtre d'ondes à plusieurs étages selon la revendication 1, dans lequel une bobine de l'inductance de sortie de premier niveau est formée en enroulant une barre plate en cuivre en plusieurs spires, et la bobine de l'inductance de sortie de deuxième niveau est formée en enroulant une barre plate en cuivre en une seule spire.

4. Le filtre d'ondes à plusieurs étages selon la revendication 1, dans lequel, parmi les extrémités de la barre plate en cuivre de sortie, une extrémité est connectée perpendiculairement à la face d'extrémité inférieure du deuxième noyau magnétique, et l'autre extrémité est collée à la surface d'extrémité inférieure du PCB de troisième étage après avoir traversé le PCB de troisième étage, la première broche d'entrée traverse le PCB de deuxième étage, puis est soudée au PCB de premier étage, et la broche de sortie et la deuxième broche d'entrée sont soudées au PCB de deuxième étage.

5. Le filtre d'ondes à plusieurs étages selon la revendication 4, dans lequel la borne de sortie de filtre comprend un siège de montage (411), un port de sortie (412) agencé à une extrémité du siège de montage et une barre plate en cuivre de connexion (413) agencée à l'autre extrémité du siège de montage ; un trou de vis de montage est disposé à une extrémité de la barre plate en cuivre de connexion éloignée du siège de montage, et un trou de vis de connexion (441) s'adaptant au trou de vis de montage est disposé à l'autre extrémité de la barre plate en cuivre de sortie, de sorte que la borne de sortie de filtre est connectée à la barre plate en cuivre de sortie en faisant passer une vis de fixation à travers le trou de vis de montage et le trou de vis de connexion.

6. Un dispositif de conversion DCDC de source d'alimentation embarquée, comprenant un boîtier (10), dans lequel le dispositif comprend en outre le filtre d'ondes à plusieurs étages selon l'une quelconque des revendications 1 à 5 installé sur le boîtier, ainsi qu'un transistor de commutation de puissance (7), un transformateur (8) et un transistor de commutation côté secondaire (9) qui sont connectés au PCB de premier étage.

7. Le dispositif de conversion DCDC de source d'alimentation embarquée selon la revendication 6, dans lequel le boîtier forme une cavité utilisée pour isoler et blinder l'inductance entre une inductance de sortie de premier niveau (1) et une inductance de sortie de deuxième niveau (4).

8. Le dispositif de conversion DCDC de source d'alimentation embarquée selon la revendication 6, dans lequel une partie de conduction thermique (20) est montée entre l'inductance de sortie de premier niveau ainsi que l'inductance de sortie de deuxième niveau et le boîtier.
